# EUROPÄISCHE PATENTSCHRIFT

(11) **EP 1 532 682 B1**
(45) Veröffentlichungstag und Bekanntmachung des Hinweises auf die Patenterteilung: **19.11.2008**
(21) Anmeldenummer: 03783936.2
(22) Anmeldetag: 29.07.2003
(51) Int. Cl.: H01L 23/58

(54) **HALBLEITERWAFER MIT ELEKTRISCH VERBUNDENEN KONTAKT- UND PRÜFFLÄCHEN**
SEMICONDUCTOR WAFER HAVING ELECTRICALLY CONNECTED CONTACT AND TESTING SURFACES
PLAQUETTE A SEMICONDUCTEURS COMPORTANT DES SURFACES DE CONTACT ET DE CONTROLE ELECTRIQUEMENT CONNECTEES

(30) Priorität: 29.07.2002 DE 10234648
(43) Veröffentlichungstag der Anmeldung: 25.05.2005
(73) Patentinhaber: Infineon Technologies AG, 81669 München (DE)
(72) Erfinder: ERTLE, Werner, 85579 Neubiberg (DE); GOLLER, Bernd, 83624 Otterfing (DE); HORN, Michael, 80804 München (DE); KOTHE, Bernd, 77870 Vulaines sur Seine (FR)
(74) Vertreter: Schäfer, Horst
(86) Internationale Anmeldenummer: PCT/DE2003/002544
(87) Internationale Veröffentlichungsnummer: WO 2004/015773

(56) Entgegenhaltungen:
- EP-A- 0 660 386
- US-A- 4 562 455
- US-A- 5 891 745
- US-B1- 6 251 694
- US-B1- 6 359 342

## Beschreibung

Die Erfindung betrifft einen Halbleiterwafer mit elektrisch verbundenen Kontakt- und Prüfflächen, sowie ein elektronisches Bauteil mit einem Halbleiterchip eines derartigen Halbleiterwafers und Verfahren zur Nachbearbeitung des Halbleiterwafers gemäß der Gattung der unabhängigen Ansprüche.

Durch eine stete Verkleinerung der Kontaktflächen auf Halbleiterwafern ergeben sich insbesondere Probleme bei dem Funktionstest auf Waferebene eines Halbleiterchips, da bei zunehmender Anzahl von Kontaktflächen pro Test bei gleichzeitiger Miniaturisierung der Abmessung der Kontaktflächen erhöhte Kontaktprobleme beim Test auftreten. Probleme entstehen auch beim Bonden von Kontaktflächen, die bereits durch den Funktionstest aufgrund der Prüfspitzen beschädigt wurden, so dass es bei der Fertigung zu erhöhtem Ausschuss kommt.

Aus der Druckschrift US 5,506,499 ist es bekannt, eine von der Kontaktfläche für ein Bonden getrennte Prüffläche vorzusehen, die mit der Kontaktfläche elektrisch verbunden ist. Für diese Ausgestaltung wird zusätzliche Chipfläche benötigt, um die zusätzliche Prüffläche neben jeder Kontaktfläche auf dem Halbleiterchip unterzubringen. Die aus der US 5,506,499 bekannte Lösung führt zu einer Vergrößerung der benötigten Chipfläche und steht Miniaturisierungsbestrebungen in der Halbleitertechnologie entgegen.

Eine ähnliche Anordnung ist auch aus der Druckschrift EP-A-0 660 386 bekannt.

Der Erfindung liegt die Aufgabe zugrunde, Halbleiterchips und elektronische Bauteile bereitzustellen, die geringere Außenmaße aufweisen, wobei eine zuverlässige Kontaktierung und Überprüfung jedes Halbleiterchips gewährleistet ist.

Gelöst wird diese Aufgabe mit dem Gegenstand der unabhängigen Ansprüche. Vorteilhafte Weiterbildungen der Erfindung ergeben sich aus den jeweiligen abhängigen Ansprüchen.

Erfindungsgemäß wird ein Halbleiterwafer mit einer Vielzahl von Halbleiterchips bereitgestellt, wobei die Halbleiterchips eine Anordnung von jeweils elektrisch leitend miteinander verbundenen Kontaktflächen und Prüfflächen aufweisen. Die Kontaktflächen sind in einem passiven ersten Bereich der Oberseite des Halbleiterchips angeordnet, der keine Komponenten einer integrierten Schaltung aufweist. Die Prüfflächen sind in einem aktiven zweiten Bereich der Oberseite des Halbleiterchips angeordnet, der Komponenten einer integrierten Schaltung aufweist.

Dieser Halbleiterwafer hat den Vorteil, dass die Prüfflächen gegenüber den Kontaktflächen wesentlich vergrößert werden können. Damit wird eine zuverlässigere Kontaktgabe der Testspitzen ermöglicht wird, weil gruppenweise auf den Halbleiterwafer aufgesetzten Prüfspitzen jeweils einen höheren Toleranzbereich für die Positionierung zur Verfügung haben. Außerdem haben die Prüfspitzen Platz kleine Bewegungen und sie können sich auf einer größeren Fläche der Prüfflächen anlegen. Gleichzeitig ist der Flächenbedarf pro Halbleiterchip vermindert, da nur noch für Kontaktflächen und nicht mehr auch für die Prüfflächen ein passiver erster Bereich der Oberfläche ohne Komponenten einer integrierten Schaltung vorgesehen werden braucht. Die Anzahl der Halbleiterchips pro Halbleiterwafer kann vergrößert werden. Außerdem wird die für je einen Halbleiterchip benötigte Fläche des Halbleiterwafers bei gleichzeitig verbesserten Prüfbedingungen und verbesserten Bondbedingungen erheblich vermindert.

Der passive erste Bereich eines Halbleiterchips wird bevorzugt für Kontaktflächen genutzt, um die Komponenten des aktiven zweiten Bereichs bei einem Verbinden mit Bonddrähten oder mit Flip-Chip-Kontakten keinen thermischen und mechanischen Belastungen auszusetzen. Damit wird der Gefahr begegnet, dass die Eigenschaften der aktiven Komponenten durch thermische und mechanische Belastungen verändert werden. Diese Belastungen treten bei einer Funktionsprüfung, die auf den Prüfflächen durchgeführt wird, nicht auf.

Auf einer gegenüber der Länge der Kontaktflächen vergrößerten Länge von Prüfflächen können auch mehrere Prüfspitzen gleichzeitig aufgesetzt werden, was die Prüfsicherheit vergrößert. So kann beispielsweise eine Prüfspitze das Mess-Signal anbieten, während eine zweite Prüfspitze auf der gleichen Prüffläche überprüft und misst, ob das Mess-Signal in voller Höhe auf der Prüffläche zur Verfügung steht.

Außerdem können in vorteilhafter Weise mehrere Prüfspitzen von Prüffläche zu Prüffläche versetzt angeordnet werden, so dass ein vorgegebener minimaler Prüfspitzenabstand eingehalten werden kann. Deswegen können erfindungsgemäße Halbleiterchips auch mit Meßapparaturen überprüft werden, deren minimaler Prüfspitzenabstand größer ist als der Mittenabstand zwischen den Kontaktflächen. So können beispielsweise Prüfkarten mit einem Mess-Spitzen-Abstand von beispielsweise 90 Mikrometern eingesetzt werden, obgleich der Mittenabstand der Kontaktflächen beispielsweise lediglich 50 Mikrometer beträgt. Gegenüber dem Stand der Technik der US 5,506,499 wird mit der Erfindung der Oberflächenbedarf für einen Halbleiterchip wesentlich verringert. Bei gleichem Oberflächenbedarf ist es dann möglich, eine größere Anzahl von Kontaktflächen bereitzustellen. Gegenüber der US 5,506,499 kann auch ein deutlich verringertes Rastermaß der Kontaktflächen erreicht werden.

Außerdem können mehrfache Messungen auf einer Prüffläche hintereinander durchgeführt werden, wobei der jeweilige Meßpunkt im Bereich der Prüffläche versetzt wird. Das Anordnen der Prüfflächen in dem zweiten Bereich der Oberseite des Halbleiterchips mit Komponenten einer integrierten Schaltung bringt somit eine größere Zuverlässigkeit der Funktionstests, ohne den Oberflächenbedarf eines Halbleiterchips zu vergrößern. Dabei können Prüfflächen und Kontaktflächen auf derselben Leiterbahnebene ausgebildet sein.

Wenn im aktiven Bereich zwischen den aktiven Komponenten einer integrierten Schaltung und den Prüfflächen eine elektrisch isolierende Schicht angeordnet ist, dann werden Kurzschlüsse zwischen den Elektroden der aktiven Komponenten einer darunter liegenden integrierten Schaltung verhindert. Auf dem passiven Bereich braucht eine solche elektrisch isolierende Schicht nicht unbedingt vorgesehen werden, weil dort keine Leiterbahnen der integrierten Schaltung austreten. Eine derartige isolierende Schicht kann Siliciumdioxid und/oder Siliciumnitrid aufweisen. Wegen der hohen Durchschlagfestigkeit diese Materialien können isolierende Schichten mit Dicken im Bereich eines Mikrometers bereits ausreichen.

Das Material der Prüfflächen und/oder der Kontaktflächen kann Aluminium oder eine Aluminiumlegierung aufweisen. Eine Kontaktfläche oder eine Prüffläche können auch die Oberseite einer mehrlagigen Beschichtung bilden, wobei die Prüffläche und/oder die Kontaktfläche Palladium oder Tantal als eine Lage in der mehrlagigen Schicht aufweisen. Palladium und Tantal bilden dabei Diffusionssperren für Siliciumatome und vermindern gleichzeitig die Migration von Aluminium beziehungsweise Aluminiumlegierungen.

Die Prüfflächen und/oder die Kontaktflächen können als oberste Lage Gold oder eine Goldlegierung aufweisen, die besonders oxidations-, korrosions- und erosionsfest ist. Weiterhin können die Prüfflächen und/oder die Kontaktflächen Kupfer oder eine Kupferlegierung als Basislage aufweisen. In diesem Fall wird eine Aluminium- oder Goldbeschichtung der Prüf- und/oder Kontaktflächen durch eine Metall-Legierungsschicht beispielsweise aus Titanlegierungen, Tantalverbindungen oder Nickellegierungen als Zwischenlage vor einer Kupferdiffusion geschützt.

Im Bereich des Leitungssteges, der zwischen einer Kontaktfläche und einer Prüffläche angeordnet ist, können besonders vorteilhaft Durchkontakte durch die isolierende Schicht zwischen Prüfkontakten und Elektroden von Komponenten der darunter liegenden integrierten Schaltung vorgesehen sein. Diese Durchkontakte verbinden die Kontaktflächen im Bereich der Leitungsstege über Leiterbahnen, die unter der isolierenden Schicht angeordnet sind, mit Elektroden der Komponenten der integrierten Schaltung. Eine Matrix aus Durchkontakten läßt die Oberfläche des Leitungssteges uneben erscheinen. Gemäß der Erfindung werden die Durchkontakte nicht mehr unterhalb der Kontaktflächen oder unterhalb der Prüfflächen angeordnet, wodurch insbesondere eine störungsfreie Kontaktfläche für das Anbringen von Bondverbindungen beziehungsweise von Flip-Chip-Kontakten zur Verfügung steht.

Derartige Leiterbahnen können aus Kupfer oder aus einer Kupferlegierung realisiert sein. Dann kann noch eine diffusionshemmende Metalllage zwischen Durchkontakten und Kupferleitungen vorgesehen werden.

Eine weitere Ausführungsform der Erfindung sieht vor, dass die Kontaktflächen hinsichtlich ihrer Abmessungen optimiert werden. Dabei ergibt sich in der Draufsicht ein quadratischer oder kreisrunder Umriss. Damit wird eine Miniaturisierung des vorzusehenden passiven ersten Bereichs einer Halbleiterchipoberfläche und damit eine vergrößerte Anzahl an Halbleiterchips auf einem Halbleiterwafer begünstigt.

Auf dem Halbleiterchip vorgesehene Isolations- und Passivierungsschichten können mehrlagig aufgebaut sein. In einer weiteren Ausführungsform der Erfindung ist unmittelbar auf den Rändern der Kontaktflächen und der Prüfflächen und auf dem gesamten verbindenden Leitungssteg eine Siliciumdioxidschicht angeordnet. Zwischen dieser Siliciumdioxidschicht und einer abschließenden Polyimidschicht wird eine Siliciumnitridschicht vorgesehen, denn eine unmittelbar auf einer Siliciumdioxidschicht vorgesehen Polyimidschicht neigt zur Delamination. Dieser erfindungsgemäße Schichtaufbau hat den Vorteil einer verbesserten Haftung.

Darüber hinaus hat diese Schichtfolge den Vorteil, dass durch chemische Gasphasenabscheidung zunächst sowohl die Siliciumdioxidschicht als auch die Siliciumnitridschicht ganzflächig und unstrukturiert abgeschieden werden können und schließlich die photoempfindliche Polyimidschicht aufgebracht werden kann, in die dann Kontaktfenster beziehungsweise Prüffenster photolithographisch eingebracht werden. Nach kurzen Plasmaätzschritten lassen sich die darunterliegende Siliciumnitridschicht und die weiterhin vorhandene Siliciumdioxidschicht selektiv entfernen, so das für das Bonden oder das Aufbringen von Flip-Chip-Kontakten die Kontaktflächen frei liegen und für ein Prüfen zusätzlich zu jeder der Kontaktflächen ein Fenster in der Isolations- und Passivierungsschicht vorhanden ist.

Besonders wenn eine große Anzahl an Durchkontakten im Bereich des Leistungssteges angeordnet werden soll, so kann dieser auch T-förmig ausgebildet sein. Dabei werden in dem breiteren Querbalken des T, welcher der Breite eines Kontaktfensters in der Passivierungsschicht entsprichen kann, die Durchkontakte zu den Kupferleiterbahnen vorgesehen. Die Breite des Längsbalkens des T kann im Hinblick auf eine maximal vorgesehene Strombelastung beim Prüfen durch Prüfspitzen optimiert werden, damit während des Prüfvorgangs keine unerwünschte Unterbrechung der elektrischen Verbindung zwischen Prüffläche und Kontaktfläche auftritt.

Die Prüfflächen können eine größere Länge als Breite aufweisen, wobei sich deren Breite nach der Breite der Kontaktflächen richtet. Vorzugsweise ist die Länge der Prüfflächen wenigstens 1,5 mal größer als deren Breite, insbesondere ist es von Vorteil, wenn die Länge der Prüffläche mindestens 2 mal größer als deren Breite ist. Die Prüfflächen haben mit diesen Längen zu Breitenverhältnissen den Vorteil, daß ein in Längsrichtung der Prüfflächen versetztes Aufsetzen von zwei Prüfspitzen auf unmittelbar nebeneinander gelegenen Prüfflächen zulässig ist. Die Länge der Prüfflächen richtet sich dabei nach einem Mindestabstand zwischen beiden Prüfspitzen. Somit können auch Prüfeinrichtungen mit Prüfspitzen verwendet werden, deren Mindestabstand wesentlich größer ist als der Mittenabstand bzw. "Pitch" zwischen den Kontaktflächen des erfindungsgemäßen Halbleiterchips. Somit kann zum Testen ein Equipment eingesetzt werden, das eigentlich nur bei vergrößertem Pitch anwendbar ist. Ein kleinerer Pitch kann dennoch mit einem leistungsstarken Equipment getestet werden, da die Prüfspitzen auf den erfindungsgemäßen Prüfflächen versetzt angeordnet werden können.

Die obenstehenden Vorteile eine erfindungsgemäßen Anordnung von Kontaktflächen und Prüfflächen gelten auch für elektronische Bauteile mit Halbleiterchips.

Mit dem erfindungsgemäßen elektronischen Bauteil brauchen anders als in der US 5,506,499 nur noch die Kontaktflächen in einem passiven ersten Bereich vorgesehen werden. Der gesamte aktive zweite Bereich der Oberseite eines Halbleiterchips mit Komponenten von integrierten Schaltungen steht dann für die Anordnung von Prüfflächen zur Verfügung. Gegenüber der US 5,506,499 kann also ein verringertes Rastermaß für Bondverbindungen beziehungsweise für Flip-Chip-Kontakte bereitgestellt werden. Gleichzeitig können die Prüfflächen beliebig groß gestaltet werden, solange ihre Breite dem Rastermaß der Bondverbindungen beziehungsweise dem Rastermaß der Flip-Chip-Kontakte angepasst ist und die benötigte Halbleiterchipfläche minimiert ist. Dadurch wird auch der Raumbedarf des erfindungsgemäßen elektronischen Bauteils vermindert.

Das Anordnen der Prüfflächen in dem zweiten Bereich der Oberseite des Halbleiterchips mit Komponenten einer integrierten Schaltung ermöglicht ferner eine höhere Dichte der möglichen Bondverbindungen beziehungsweise der möglichen Flip-Chip-Kontakte für einen Halbleiterchip ohne den Oberflächenbedarf eines Halbleiterchips zu vergrößern. Vielmehr wird der Oberflächenbedarf gegenüber der aus der US 5,506,499 bekannten Lösung weiter verringert.

Bei einem erfindungsgemäßen Verfahren wird ein Halbleiterwafer mit einer Vielzahl von Bereichen je eines Halbleiterchips nachgearbeitet. Nach dem Bereitstellen eines Halbleiterwafers, der Prüfflächen in einem Bereich mit Komponenten einer integrierten Schaltung aufweist, wird darauf einer Funktionsprüfung durchgeführt. Dabei werden defekte Halbleiterchips markiert und - optional - danach die Prüfflächen der Halbleiterchips auf dem gesamten Wafer versiegelt. Das Versiegeln der Prüfflächen kann dabei durch Aufbringen einer insbesondere strukturierten Photolackschicht oder Lötstopplackschicht erfolgen, und zwar unter Freilassen der Kontaktflächen. Dabei verhindert die Lötstopplackschicht ein späteres ungewolltes Kontaktieren der Prüfflächen mit Flip-Chip-Technik, denn dann können keine Lötballs mehr daran haften bleiben. Ein etwaiger vorgesehener Photolack reicht für das Vermeiden von Fehlbondungen aus.

Zusammenfassend ist festzustellen, dass das wesentliche Problem eines Probing bzw. Prüfen der Funktionsfähigkeit eines Halbleiterchips auf Waferebene und eines Bondens zur Herstellung von Bondverbindungen durch Trennung der Öffnungen bzw. Fenster für das Probing und das Bonden mit dieser Erfindung gelöst wird. Darüber hinaus werden die Prüföffnungen in dieser Erfindung über aktiven Strukturen angeordnet, so dass lediglich für die Kontaktöffnungen und die Kontaktflächen zusätzliche Halbleiterflächenbereiche ohne jede aktive Funktion einzusetzen sind bzw. benötigt werden.

Damit kann die Probing-Öffnung über aktiven Strukturen ohne Einfluss auf die Chipflächengröße relativ groß gewählt werden, wobei diese Größe es dann erlaubt, dass durch vertikale Prüfspitzen oder Nadelkarten, wie sie sonst nur für große Rastermaße eingesetzt werden, auch für beliebig verringerte Rastermaße nun verwendet werden können, wenn beispielsweise die Prüfspitzen beziehungsweise Nadeln in zwei Reihen versetzt zueinander angeordnet werden.

Die Erfindung wird anhand von Ausführungsformen mit Bezug auf die beiliegenden Figuren näher erörtert.
- Figur 1: zeigt schematisch eine Anordnung von Kontaktflächen und Prüfflächen auf einem Halbleiterchip gemäß ei- ner ersten Ausführungsform der Erfindung,
- Figur 2: zeigt einen schematischen Querschnitt durch einen Halbleiterchip mit der in Figur 1 gezeigten Anord- nung, und
- Figur 3: zeigt schematisch eine Anordnung einer Kontaktflä- che und einer Prüffläche mit verbindendem Leitungs- steg gemäß einer zweiten Ausführungsform der Erfin- dung.

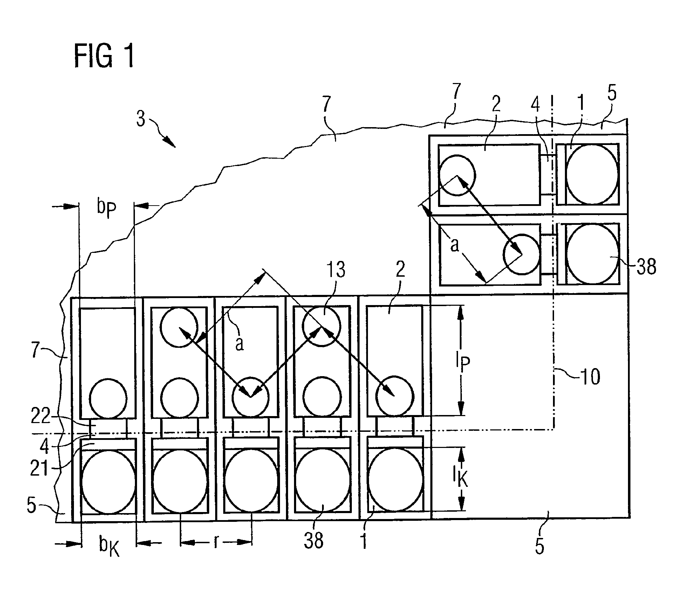

Figur 1 zeigt einen Abschnitt eines Halbleiterchips 3 gemäß einer ersten Ausführungsform der Erfindung. Der Halbleiterchip 3 gliedert sich in einen passiven ersten Bereich 5, der keine Komponenten einer integrierten Schaltung aufweist, und in einen zweiten Bereich 7, der aktive Komponenten einer hier nicht sichtbaren integrierten Schaltung aufweist. Die Grenze zwischen dem ersten Bereich 5 und dem zweiten Bereich 7 ist durch die strichdoppelpunktierte Linie 10 markiert.

Auf dem ersten Bereich 5 sind Kontaktflächen 1 angeordnet. Auf dem zweiten Bereich 7 sind Prüfflächen 2 vorgesehen. Die Breite bₖ der Kontaktflächen 1 richtet sich nach dem gewünschten Rastermaß r der Bondverbindungen beziehungsweise nach dem gewünschten Rastermaß r der Flip-Chip-Kontakte, die darauf unterzubringen sind. Hier beträgt das Rastermaß r ca. 60 µm. Die Breite bₖ der Kontaktflächen 1 beträgt ca. 52 µm. Die Kontaktflächen 1 sind hinsichtlich Ihrer Flächenausdehnung zu dem gewünschten Rastermaß optimiert und weisen eine quadratische Struktur auf. Die Länge lₖ der Kontaktflächen 1 beträgt dementsprechend ca. 52 µm.

Je eine Kontaktfläche 1 und eine Prüffläche 2 sind über einen Leitungssteg 4 miteinander verbunden. Diese Komponenten sind in Mikrometer-Technologie hergestellt. Der Leitungssteg 4 ist T-förmig ausgebildet. In seinem Querbalken 21 weist er hier nicht gezeigte Durchkontakte zu darunter liegenden Leiterbahnlagen auf.

Auf den Kontaktflächen 1 sind Bondballs 38 angeordnet.

Die Oberfläche des Halbleiterchips 3 ist bis auf Bereiche von Kontaktfenstern und Prüffenstern, die hier mit den Kontaktflächen 1 und mit den Prüfflächen 2 übereinstimmen, von einer Isolations- und Passivierungsschicht bedeckt. Diese Isolations- und Passivierungsschicht wird im wesentlichen zum Schutz der aktiven Komponenten der integrierten Halbleiterschaltungen im zweiten Bereich 7 aufgebracht.

Der T-förmige Leitungssteg 4 weist einen Längsbalken 22 auf, der den Bereich der Kontaktfläche 1 mit dem Bereich der Prüffläche 2 verbindet. Die Prüffläche 2 kann bei gleichbleibender Breite bp prinzipiell eine beliebige Länge lₚ aufweisen, ohne daß eine zusätzliche Oberfläche des Halbleiterchips 3 verbraucht wird. In dieser Ausführungsform der Erfindung beträgt die Länge lₚ beträgt 125 µm. Aus den geometrischen Randbedingungen ergibt sich, dass mit einer Prüfspitzenkarte gearbeitet werden kann, die einen minimalen Abstand zwischen den Prüfspitzen von 90 µm vorschreibt, ohne dass dabei Probleme auftreten. Der Abstand a in Figur 1 kennzeichnet den minimalen Prüfspitzenabstand zwischen zwei Meßpunkten 13 einer solchen Prüfspitzenkarte. Dazu sind die Messpunkte 13 von benachbarten Prüfflächen 2 bezüglich der Längsachse der Prüfflächen versetzt zueinander angeordnet.

In einem hier nicht gezeigten Ausführungsbeispiel sind die Prüfflächen derart verlängert, daß auf einer Prüffläche zwei Prüfspitzen gleichzeitig aufgesetzt werden können.

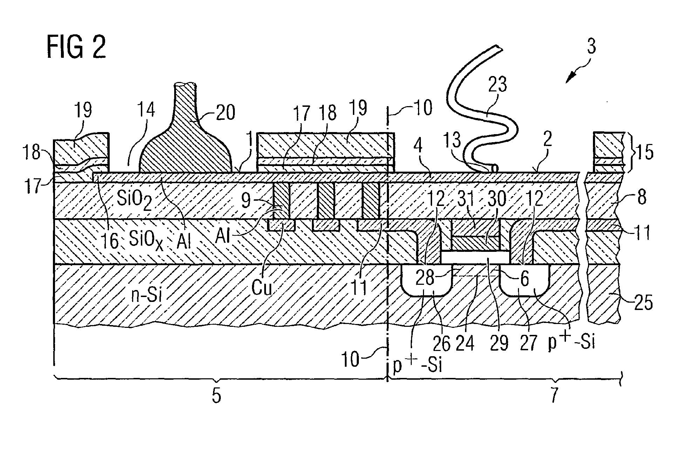

Figur 2 zeigt einen Querschnitt durch einen Halbleiterchip 3 mit der in Figur 1 gezeigten Anordnung von Kontaktflächen 1 und Prüfflächen 2. Komponenten mit gleichen Funktionen wie in Figur 1 werden mit gleichen Bezugszeichen gekennzeichnet und nicht extra erörtert.

Die hier gezeigte Anordnung aus Kontaktfläche 1, aus verbindendem Leitungssteg 4 und aus Prüffläche 2 weist eine einlagige Schicht Al aus einer Aluminiumlegierung auf. Im Bereich des Leitungssteges 4 ist diese Schicht mit Durchkontakten 9 verbunden, die aus einer Aluminiumlegierung aufgebaut sind. Die Durchkontakte 9 gehen durch die elektrisch isolierende Schicht 8 aus Siliciumdioxid hindurch und verbinden die Kontaktfläche 1 mit darunter liegenden, in Sub-Mikrometer-Technologie hergestellten Leiterbahnen 11 aus Kupfer. Diese Leiterbahnen 11 reichen in den aktiven Bereich 7 des Halbleiterchips 3 hinein, der in dieser Ausführungsform der Erfindung mehrere MOS-Transistoren 24 aufweist.

Diese MOS-Transistoren 24 sind in einen n-leitenden Siliciumeinkristallbereich 25 eingebettet und weisen einen p⁺-Si-Bereich als Source 26 des MOS-Transistors 24 auf und einen weiteren p⁺-Si-Bereich als Drain 27 auf. Dazwischen ist ein Kanalbereich 28 angeordnet, der von einem Gateoxid 29 abgedeckt ist und von einer in Sub-Mikrometer-Technologie realisierten Gateelektrode 30 aus polykristallinem Silicium gesteuert wird. Darüber ist eine Kupferzuleitung 31 angeordnet, die mit den Durchkontakten 9 in Verbindung stehen kann. Zwischen einem derartigen aktiven Bauelement einer integrierten Schaltung und der Prüffläche 2 ist die elektrisch isolierende Schicht 8 angeordnet, die in dieser Ausführungsform der Erfindung Siliciumdioxid aufweist. Beim Testen der Funktion des Halbleiterchips 3 mit einer Testspitze 23 im darüber liegenden Messpunkt 13 wird somit die darunter liegende aktive Komponente nicht elektrisch belastet. Eine mechanische Belastung dieser darunter liegenden Komponenten wird durch das Vorsehen der elastisch ausgestalteten Testspitze vermieden.

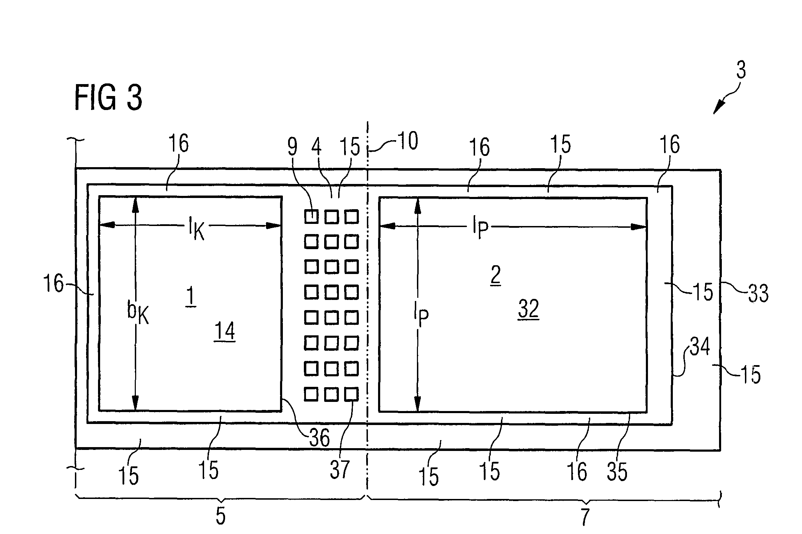

Figur 3 zeigt eine schematische Draufsicht auf eine erfindungsgemäße Anordnung innerhalb einer Begrenzungslinie 33, deren Breite dem Rastermaß gewünschter Bondverbindungen beziehungsweise dem Rastermaß gewünschter Flip-Chip-Kontakte von ca. 60 µm. entspricht. Komponenten mit gleichen Funktionen wie in den vorhergehenden Figuren werden mit gleichen Bezugszeichen gekennzeichnet und nicht extra erörtert. Die Anordnung ist mit dem kleineren Anteil über dem ersten passiven Bereich 5 und mit einem größeren Anteil auf dem zweiten Bereich 7 mit aktiven Bauteilen des Halbleiterchips 3 angeordnet. Die strichdoppelpunktierte Linie 10 kennzeichnet die Grenze zwischen dem darunter liegenden passivem Bereich 5 und dem darunter liegenden zweiten aktiven Bereich 7.

Die Anordnung ist auf einer durchgehenden metallisierten Fläche ausgebildet, deren Außenkontur durch die Begrenzungslinie 34 beschrieben wird. Auf der metallisierten Fläche ist eine Kontaktfläche 1 und eine Prüffläche 2 vorgesehen, und zwar jeweils mit einer Breite von ca. 56 µm. Dazwischen liegt in gleichbleibender Breite von ca. 56 µm ein Bereich eines Leitungsstegs 4, von dem aus Durchkontakte 9 zu darunter liegenden Kupferleiterbahnen führen.

Nahezu der gesamte Bereich des Leitungsstegs 4 einschließlich der Durchkontakte 9 ist von der Isolations- und Passivierungsschicht 15 bedeckt. Die Isolations- und Passivierungsschicht 15 deckt auch die Ränder 16 der Kontaktfläche 1 und der Prüffläche 2 ab. Nur ein quadratisches Kontaktfenster 14 von 52 x 52 µm und ein rechteckförmiges Prüffenster 32 von 52 x 125 µm bleiben von der Isolations- und Passivierungsschicht 15 frei. Innerhalb des Kontaktfensters 14 und des Prüffensters 32 bleibt ein Zugriff auf die metallisierte Fläche bestehen.

Nach dem Prüfen auf dem Prüffenster 32 wird dieses mit einer hier nicht dargestellten Schutzschicht versiegelt.

## Patentansprüche

1. Halbleiterwafer mit einer Vielzahl von Halbleiterchips,
- wobei die Halbleiterchips eine Anordnung von jeweils elektrisch leitend miteinander verbundenen Kontaktflächen (1) und Prüfflächen (2) aufweisen, und
- wobei die Kontaktflächen (1) in einem ersten passiven Bereich (5) der Oberseite des Halbleiterchips (3) angeordnet sind, der keine Komponenten (6) einer integrierten Schaltung aufweist, und
- wobei die Prüfflächen (2) in einem zweiten aktiven Bereich (7) der Oberseite des Halbleiterchips (3) angeordnet sind, der Komponenten (6) einer integrierten Schaltung aufweist.

2. Halbleiterchip mit einer Anordnung von jeweils elektrisch leitend miteinander verbundenen Kontaktflächen (1) und Prüfflächen (2), wobei die Kontaktflächen (1) in einem passiven ersten Bereich (5) der Oberseite des Halbleiterchips (3) angeordnet sind, der keine Komponenten (6) einer integrierten Schaltung aufweist und wobei die Prüfflächen (2) in einem aktiven zweiten Bereich (7) der Oberseite des Halbleiterchips (3) angeordnet sind, der Komponenten (6) einer integrierten Schaltung aufweist.

3. Elektronisches Bauteil mit einem Halbleiterchip,
- wobei der Halbleiterchip eine Anordnung von jeweils elektrisch leitend miteinander verbundenen Kontaktflächen (1) und Prüfflächen (2) aufweist,
- wobei die Kontaktflächen (1) in einem passiven ersten Bereich (5) der Oberseite des Halbleiterchips (3) angeordnet sind, der keine Komponenten (6) einer integrierten Schaltung aufweist,
- wobei die Prüfflächen (2) in einem aktiven zweiten Bereich (7) der Oberseite des Halbleiterchips (3) angeordnet sind, der Komponenten (6) einer integrierten Schaltung aufweist,
- wobei Prüfflächen (2) und Kontaktflächen (1) in derselben Leiterbahnebene ausgebildet sind, und
- wobei die Länge (lp) der Prüfflächen (2) wenigstens ca. 1,5 mal größer ist als deren Breite (bp).

4. Halbleiterwafer oder Halbleiterchip oder elektronisches Bauteil nach Anspruch 4 oder Anspruch 2 oder Anspruch 3,
**dadurch gekennzeichnet, dass** zwischen den Komponenten (6) einer integrierten Schaltung und den Prüfflächen (2) des Halbleiterchips (3) mindestens eine elektrisch isolierende Schicht (8) mit insbesondere Siliciumdioxid und/oder Siliciumnitrid angeordnet ist.

5. Halbleiterwafer oder Halbleiterchip oder elektronisches Bauteil nach einem der vorhergehenden Ansprüche,
**dadurch gekennzeichnet, dass**
die Kontaktflächen (1) und die Prüfflächen (2) über einen Leitungssteg (4) elektrisch leitend verbunden sind.

6. Halbleiterwafer oder Halbleiterchip oder elektronisches Bauteil nach Anspruch 5,
**dadurch gekennzeichnet, dass** im Bereich des Leitungssteges (4) Durchkontakte (9) durch eine isolierende Schicht (8) angeordnet sind, wobei die Durchkontakte (9) mit Leiterbahnen (11) zu den Elektroden (12) der Komponenten (6) der integrierten Schaltung verbunden sind.

7. Halbleiterwafer oder Halbleiterchip oder elektronisches Bauteil nach Anspruch 6,
**dadurch gekennzeichnet, dass**
die Leiterbahnen (11) zu den Elektroden (12) der Komponenten (6) der integrierten Schaltung Kupfer oder eine Kupferlegierung aufweisen.

8. Halbleiterwafer oder Halbleiterchip oder elektronisches Bauteil nach einem der Ansprüche 5 bis 7,
**dadurch gekennzeichnet, dass**
die Kontaktflächen (1) und die Prüfflächen (2) an ihren Rändern (16) und der Leitungssteg (4) auf seiner Oberseite eine mehrlagige Isolations- und Passivierungsschicht (15) aufweisen.

9. Halbleiterwafer oder Halbleiterchip oder elektronisches Bauteil nach Anspruch 8,
**dadurch gekennzeichnet, dass** die mehrlagige Isolation- und Passivierungsschicht (15) eine Siliciumdioxidschicht (17) aufweist, die unmittelbar auf den Rändern (16) der Kontaktflächen (1) und der Prüfflächen (2) und auf dem verbindenden Leitungssteg (4) angeordnet ist.

10. Halbleiterwafer oder Halbleiterchip oder elektronisches Bauteil nach Anspruch 8 oder Anspruch 9,
**dadurch gekennzeichnet, dass**
die mehrlagige Isolations- und Passivierungsschicht (15) eine Siliciumnitridschicht (18) und eine Polyimidschicht (19) aufweist.

11. Halbleiterwafer oder Halbleiterchip oder elektronisches Bauteil nach einem der Ansprüche 5 bis 10,
**dadurch gekennzeichnet, dass**
der Leitungssteg (4) T-förmige ausgebildet ist, wobei der Querbalken (21) des T an die Breite der Kontaktflächen angepasst ist und Durchkontakte (9) zu Leiterbahnen (11) aufweist, während der Längsbalken (22) des T der maximalen Strombelastung beim Prüfen durch Prüfspitzen (23) angepasst ist.

12. Halbleiterwafer oder Halbleiterchip oder elektronisches Bauteil nach einem der vorhergehenden Ansprüche,
**dadurch gekennzeichnet, dass**
die Prüfflächen (2) in ihrer Breite (bₚ) der Breite der Kontaktflächen angepasst sind und eine Länge (lₚ) aufweisen, die größer ist als ihre Breite (bₚ).

13. Verfahren zur Nachbearbeitung eines Halbleiterwafers gemäß einem der Ansprüche 1 oder 4 bis 12, wobei das Verfahren folgende Verfahrensschritte aufweist:
- Bereitstellen des Halbleiterwafers,
- Durchführen einer Funktionsprüfung mit einer Prüfeinrichtung, die Prüfspitzen aufweist,
- Markieren der defekten Halbleiterchips.

14. Verfahren nach Anspruch 13,
**dadurch gekennzeichnet, daß**
der Schritt des Versiegelns der Prüfflächen vorgesehen ist.

15. Verfahren nach Anspruch 14,
**dadurch gekennzeichnet, daß**
das Versiegeln der Prüfflächen durch Aufbringen einer strukturierten Photolackschicht oder Lötstopplackschicht erfolgt.

16. Verfahren nach einem der Ansprüche 13 bis 15,
**dadurch gekennzeichnet, daß**
die Prüfspitzen beim Durchführen einer Funktionsprüfung von Prüffläche zu Prüffläche versetzt angeordnet werden.

## Claims

1. Semiconductor wafer having a multiplicity of semiconductor chips,
- the semiconductor chips having an arrangement of contact areas (1) and test areas (2) which are in each case electrically conductively connected to one another, and
- the contact areas (1) being arranged in a first, passive region (5) of the top side of the semiconductor chip (3), which region has no components (6) of an integrated circuit, and
- the test areas (2) being arranged in a second, active region (7) of the top side of the semiconductor chip (3), which region has components (6) of an integrated circuit.

2. Semiconductor chip having an arrangement of contact areas (1) and test areas (2) which are in each case electrically conductively connected to one another, the contact areas (1) being arranged in a passive, first region (5) of the top side of the semiconductor chip (3), which region has no components (6) of an integrated circuit, and the test areas (2) being arranged in an active, second region (7) of the top side of the semiconductor chip (3), which region has components (6) of an integrated circuit.

3. Electronic device having a semiconductor chip,
- the semiconductor chip having an arrangement of contact areas (1) and test areas (2) which are in each case electrically conductively connected to one another,
- the contact areas (1) being arranged in a passive, first region (5) of the top side of the semiconductor chip (3), which region has no components (6) of an integrated circuit,
- the test areas (2) being arranged in an active, second region (7) of the top side of the semiconductor chip (3), which region has components (6) of an integrated circuit,
- test areas (2) and contact areas (1) being formed in the same interconnect plane, and
- the length (lp) of the test areas (2) being at least approximately 1.5 times greater than the width (bp) thereof.

4. Semiconductor wafer or semiconductor chip or electronic device according to claim 1 or claim 2 or claim 3,
**characterized in that**
at least one electrically insulating layer (8) having, in particular, silicon dioxide and/or silicon nitride is arranged between the components (6) of an integrated circuit and the test areas (2) of the semiconductor chip (3).

5. Semiconductor wafer or semiconductor chip or electronic device according to one of the preceding claims,
**characterized in that**
the contact areas (1) and the test areas (2) are electrically conductively connected via a conduction web (4).

6. Semiconductor wafer or semiconductor chip or electronic device according to claim 5,
**characterized in that**
through contacts (9) through an insulating layer (8) are arranged in the region of the conduction web (4), the through contacts (9) being connected to interconnects (11) to the electrodes (12) of the components (6) of the integrated circuit.

7. Semiconductor wafer or semiconductor chip or electronic device according to claim 6,
**characterized in that**
the interconnects (11) to the electrodes (12) of the components (6) of the integrated circuit have copper or a copper alloy.

8. Semiconductor wafer or semiconductor chip or electronic device according to one of claims 5 to 7,
**characterized in that**
the contact areas (1) and the test areas (2) at their edges (16) and the conduction web (4) on its top side have a multilayer insulation and passivation layer (15).

9. Semiconductor wafer or semiconductor .chip or electronic device according to claim 8,
**characterized in that**
the multilayer insulation and passivation layer (15) has a silicon dioxide layer (17) arranged directly on the edges (16) of the contact areas (1) and of the test areas (2) and on the connecting conduction web (4).

10. Semiconductor wafer or semiconductor chip or electronic device according to claim 8 or claim 9,
**characterized in that**
the multilayer insulation and passivation layer (15) has a silicon nitride layer (18) and a polyimide layer (19).

11. Semiconductor wafer or semiconductor chip or electronic device according to one of claims 5 to 10,
**characterized in that**
the conduction web (4) is formed in T-shaped fashion, the transverse bar (21) of the T being adapted to the width of the contact areas and having through contacts (9) to interconnects (11), while the longitudinal bar (22) of the T is adapted to the maximum current loading during testing by test tips (23).

12. Semiconductor wafer or semiconductor chip or electronic device according to one of the preceding claims,
**characterized in that**
the test areas (2) are adapted in their width (bₚ) to the width of the contact areas and have a length (lₚ) greater than their width (bₚ).

13. Method for postprocessing of a semiconductor wafer according to one of claims 1 or 4 to 12, the method having the following method steps of:
- providing the semiconductor wafer,
- carrying out a functional test with a test device having test tips,
- marking the defective semiconductor chips.

14. Method according to claim 13,
**characterized in that**
the step of sealing the test areas is provided.

15. Method according to claim 14,
**characterized in that**
the test areas are sealed by application of a patterned photoresist layer or soldering resist layer.

16. Method according to one of claims 13 to 15,
**characterized in that**
the test tips are arranged in offset fashion from test area to test area when carrying out a functional test.

## Revendications

1. Plaquette semi-conductrice avec une multiplicité de puces semi-conductrices :
- dans laquelle les puces semi-conductrices comportent un arrangement de surfaces de contact (1) et de surfaces de test (2) reliées respectivement entre elles par des liaisons électriquement conductrices ; et
- dans laquelle les surfaces de contact (1) sont disposées dans une première zone passive (5) de la face supérieure de la puce semi-conductrice (3), qui ne comporte pas de composants (6) d'un circuit intégré, et
- dans laquelle les surfaces de test (2) sont disposées dans une deuxième zone active (7) de la face supérieure de la puce semi-conductrice (3), qui comporte des composants (6) d'un circuit intégré.

2. Puce semi-conductrice avec un arrangement de surfaces de contact (1) et de surfaces de test (2) reliées respectivement entre elles par des liaisons électriquement conductrices, dans laquelle les surfaces de contact (1) sont disposées dans une première zone passive (5) de la face supérieure de la puce semi-conductrice (3), qui ne comporte pas de composants (6) d'un circuit intégré et dans laquelle les surfaces de test (2) sont disposées dans une deuxième zone active (7) de la face supérieure de la puce semi-conductrice (3), qui comporte des composants (6) d'un circuit intégré.

3. Composant électronique avec une puce semi-conductrice,
- dans lequel la puce semi-conductrice comporte un arrangement de surfaces de contact (1) et de surfaces de test (2) reliées respectivement entre elles par des liaisons électriquement conductrices,
- dans lequel les surfaces de contact (1) sont disposées dans une première zone passive (5) de la face supérieure de la puce semi-conductrice (3), qui ne comporte pas de composants (6) d'un circuit intégré,
- dans lequel les surfaces de test (2) sont disposées dans une deuxième zone active (7) de la face supérieure de la puce semi-conductrice (3), qui comporte des composants (6) d'un circuit intégré,
- dans lequel des surfaces de test (2) et des surfaces de contact (1) sont formées dans le même plan de pistes conductrices, et
- dans lequel la longueur (lₚ) des surfaces de test (2) est au moins 1,5 fois supérieure à leur largeur (bₚ).

4. Plaquette semi-conductrice ou puce semi-conductrice ou composant électronique selon la revendication 1 ou la revendication 2 ou la revendication 3, **caractérisé en ce qu'**au moins une couche (8) électriquement isolante avec notamment du dioxyde de silicium et/ou du nitrure de silicium est disposé entre les composants (6) d'un circuit intégré et les surfaces de test (2) de la puce semi-conductrice (3).

5. Plaquette semi-conductrice ou puce semi-conductrice ou composant électronique selon une des revendications précédentes, **caractérisé en ce que** les surfaces de contact (1) et les surfaces de test (2) sont reliées électriquement par l'intermédiaire d'une connexion (4) conductrice.

6. Plaquette semi-conductrice ou puce semi-conductrice ou composant électronique selon la revendication 5, **caractérisé en ce que** dans la zone de connexion (4), des contacts traversants (9) sont disposés à travers une couche isolante (8), les contacts traversants (9) étant reliés par des pistes conductrices (11) allant aux électrodes (12) des composants (6) du circuit intégré.

7. Plaquette semi-conductrice ou puce semi-conductrice ou composant électronique selon la revendication 6, **caractérisé en ce que** les pistes conductrices (11) allant aux électrodes (12) des composants (6) du circuit intégré comportent du cuivre ou un alliage de cuivre.

8. Plaquette semi-conductrice ou puce semi-conductrice ou composant électronique selon une des revendications 5 à 7, **caractérisé en ce que** les surfaces de contact (1) et les surfaces de test (2) sur leurs bords (16) et la connexion (4) sur sa face supérieure comportent une couche d'isolation et de passivation (15) à plusieurs épaisseurs.

9. Plaquette semi-conductrice ou puce semi-conductrice ou composant électronique selon la revendication 8, **caractérisé en ce que** la couche d'isolation et de passivation (15) à plusieurs épaisseurs comporte une couche de dioxyde de silicium (17) qui est directement disposée sur les bords (16) des surfaces de contact (1) et des surfaces de test (2) et sur la connexion (4) de liaison.

10. Plaquette semi-conductrice ou puce semi-conductrice ou composant électronique selon la revendication 8 ou la revendication 9, **caractérisé en ce que** la couche d'isolation et de passivation (15) à plusieurs épaisseurs comporte une couche de nitrure de silicium (18) et une couche de polyimide (19).

11. Plaquette semi-conductrice ou puce semi-conductrice ou composant électronique selon une des revendications 5 à 10, **caractérisé en ce que** la connexion (4) est réalisée en forme de T, la barre transversale (21) du T étant adaptée à la largeur de la surface de contact et comportant des contacts traversants (9) reliés aux pistes conductrices (11), alors que la barre longitudinale (22) du T est adaptée à l'intensité maximale du courant lors du test au moyen de pointes de test (23).

12. Plaquette semi-conductrice ou puce semi-conductrice ou composant électronique selon une des revendications précédentes, **caractérisé en ce que** la largeur (bₚ) des surfaces de test (2) est adaptée à la largeur des surfaces de contact et qu'elles comportent une longueur (lₚ) supérieure à leur largeur (bₚ).

13. Procédé pour le retraitement d'une plaquette semi-conductrice selon une des revendications 1 ou 4 à 12, dans lequel le procédé comporte les étapes suivantes du procédé :
- préparation de la plaquette semi-conductrice
- exécution d'un test de fonctionnement avec une station de test comportant des pointes de test,
- marquage des puces semi-conductrices défectueuses.

14. Procédé selon la revendication 13, **caractérisé en ce qu'**on a prévu l'étape de scellement des surfaces de test.

15. Procédé selon la revendication 14, **caractérisé en ce que** le scellement des surfaces de test est effectué en déposant une couche structurée de résine photosensible ou une couche structurée de résine de réserve de soudure.

16. Procédé selon une des revendications 13 à 15, **caractérisé en ce qu'**on déplace les pointes de test de surface de test à surface de test lors de l'exécution d'un test de fonctionnement.
